# FASCICULE DE BREVET EUROPEEN

(11) **EP 3 155 505 B1**
(45) Date de publication et mention de la délivrance du brevet: **13.03.2019**
(21) Numéro de dépôt: 15727969.6
(22) Date de dépôt: 09.06.2015
(51) Int. Cl.: G06F 3/041, G06F 3/044, G06F 1/16, H03K 17/96, H03K 17/975

(54) **DISPOSITIF DE MAINTIEN DE SURFACE TACTILE**
VORRICHTUNG ZUM HALTEN EINER BERÜHRUNGSEMPFINDLICHEN OBERFLÄCHE
DEVICE FOR HOLDING A TOUCH-SENSITIVE SURFACE

(30) Priorité: 11.06.2014 FR 1455301
(43) Date de publication de la demande: 19.04.2017
(73) Titulaire: Commissariat à l'Énergie Atomique et aux Énergies Alternatives, 75015 Paris (FR)
(72) Inventeur: GUENARD, Nicolas, F-78400 Chatou (FR); BOLZMACHER, Christian, F-92120 Montrouge (FR); HAFEZ, Moustapha, F-94110 Arcueil (FR)
(74) Mandataire: Lopez, Frédérique
(86) Numéro de dépôt international: PCT/EP2015/062762
(87) Numéro de publication internationale: WO 2015/189166

(56) Documents cités:
- WO-A2-02/084244
- US-A- 3 657 475
- US-A1- 2011 157 087
- US-A1- 2012 120 625
- US-A1- 2014 028 950

## Description

### Domaine de l'invention

L'invention est dans le domaine des surfaces tactiles et concerne plus particulièrement un dispositif de maintien d'une telle surface.

### Etat de la Technique

Il existe différentes approches pour rendre tactile une surface de n'importe quelle nature, en permettant de localiser un appui sur la surface. Les solutions connues sont principalement le déploiement d'un film capacitif sur la surface, la pose d'un cadre infrarouge sur la surface ou la mesure d'effort à partir de jauges de contraintes ou de capteurs de pression.

Le brevet US 3,657,475 décrit quatre capteurs s'interposant entre un support fixe et une surface tactile aux quatre coins de cette dernière. Ces capteurs sont des jauges de contrainte ou des capteurs piézoélectriques. Ils doivent, d'une part, supporter le poids à vide de la surface tactile et, d'autre part, rester sensibles à des touchers dont la force ou la pression s'ajoute au poids de cette surface tactile. La force du toucher ne peut donc pas être trop faible par rapport au poids de la surface pour ne pas induire des problèmes de sensibilité ainsi que de précision. En outre, les capteurs employés dans ce document sont assez coûteux et les capteurs piézoélectriques en particulier sont sensibles aux variations de température.

Toutes ces solutions sont particulièrement adaptées aux surfaces dites de petite taille en général inférieures à une trentaine de pouces, comme les tablettes par exemple. Cependant, elles deviennent inappropriées pour des surfaces à tactiliser plus importantes comme par exemple des vitres pour des tables ou pour des plafonniers de voiture.

En effet, le passage à des surfaces plus importantes génère des problèmes liés à la rigidité et donc à la déformation de la surface sous l'application d'une force d'interaction. Même si des solutions satisfaisantes sont proposées pour aborder cet aspect de déformation d'une surface, des inconvénients demeurent dont entre autre celui de la difficulté à avoir un bon maintien de la surface du fait des dimensions plus importantes.

La plupart des dispositifs existants pour maintenir des surfaces tactiles utilisent généralement un élément élastique permettant de plaquer la surface à rendre tactile contre le capteur de force. Ce dernier se situe alors entre la surface et un bâti. De tels dispositifs sont par exemple décrits dans les brevets US7109976 ou US7149571.

Un autre dispositif décrit dans la demande EP0497398 A2, permet de maintenir une plaque verticale ou horizontale par des moyens de suspension sur la partie haute de la plaque et des éléments élastiques sur la partie basse. Le dispositif de maintien n'ayant pour but que de soulager le poids de la plaque, des jauges de contraintes reliées à des éléments de montage permettent ensuite de mesurer les forces engendrées par l'interaction.

Le brevet précité US7109976 décrit un dispositif d'attachement pour écran d'affichage qui comprend une base ayant des première et seconde surfaces, et une partie s'étendant à partir de la deuxième surface. La base est configurée pour être montée sur l'écran et être positionnée entre l'écran et une structure demeurant adjacente à l'écran, par exemple une lunette ou un cadre de l'écran. Même si cet arrangement évite que certains corps étrangers ne passent entre l'écran et la structure adjacente, des poussières et des liquides peuvent stagner dans la cuvette ainsi formée. Par ailleurs, une précontrainte s'ajoutant au poids de la surface est appliquée par un élément élastique sur le capteur d'effort et vient modifier la plage de fonctionnement du capteur au détriment de sa sensibilité.

Ainsi, il n'existe pas dans l'art antérieur, de solution qui pallie les inconvénients des approches existantes, et qui soit adaptée au maintien d'une surface de grande dimension à tactiliser. La présente invention répond à ce besoin.

### Résumé de l'invention

Un objet de la présente invention est de fournir un dispositif pour maintenir une surface tactile de grande taille, afin d'éviter les déformations de la surface.

Avantageusement, le dispositif de l'invention permet le maintien d'une surface en plusieurs points pour augmenter la rigidité apparente de la surface et éviter son enfoncement lors de l'interaction.

Un autre objet de la présente invention est de proposer un dispositif modulaire de fixation d'une surface tactile de grande taille permettant facilement l'ajout ou le retrait de modules de fixation.

Avantageusement, le dispositif de l'invention permet de limiter la déformation de la surface à tactiliser en la fixant sur un bâti encastrable.

Un autre objet de la présente invention est de fournir un dispositif de fixation d'une surface à tactiliser offrant une mise en oeuvre aisée et un coût d'implémentation réduit.

Un autre objet de l'invention est de fournir un dispositif qui combine les fonctions de maintien d'une surface à tactiliser à celles de détection d'une interaction sur la surface. Dans un mode de réalisation, le dispositif de l'invention peut être couplé à un module électronique afin d'effectuer des mesures capacitives, et être associé à un procédé de localisation d'interaction permettant de déterminer un point d'interaction sur la surface.

La présente invention s'appliquera avantageusement pour des bornes interactives de grande taille, des meubles à tactiliser, ou encore toute application dite «simple touché».

De par le faible coût du dispositif proposé, une application typique pourra être la tactilisation d'un plafonnier de grande taille dans l'habitacle d'une automobile. Avantageusement, le dispositif proposé n'altère pas la transparence du plafonnier, et est particulièrement bien adapté pour laisser passer la lumière.

Pour obtenir les résultats recherchés, l'invention propose un dispositif selon la revendication 1. Des variantes avantageuses sont définies dans les revendications 2-9.

### Description des figures

Différents aspects et avantages de l'invention vont apparaitre en appui de la description d'un mode préféré d'implémentation de l'invention mais non limitatif, avec référence aux figures ci-dessous :
La Figure 1 montre en vue de côté un schéma de principe du dispositif de maintien de l'invention dans un mode de réalisation;
La Figure 2 montre en vue de côté une variante d'implémentation du dispositif de maintien de la figure 1;
Les figures 3a à 3b montrent des variantes d'agencement du dispositif de maintien de l'invention ;
Les figures 4a à 4c montrent des vues 3D d'un bâti monolithique selon des variantes d'implémentation du dispositif de maintien de l'invention.

### Description détaillée de l'invention

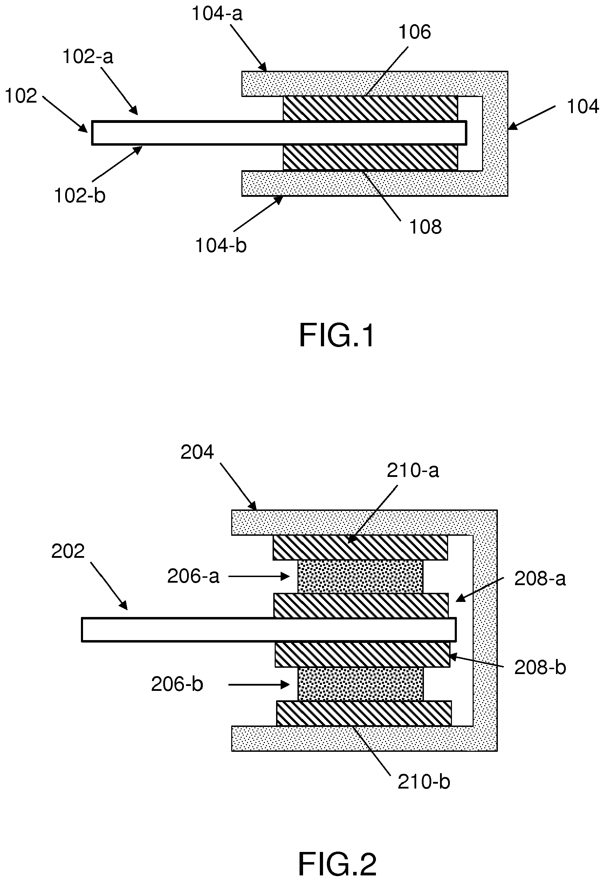

La Figure 1 montre en vue de côté un schéma de principe du dispositif de maintien de l'invention dans un mode de réalisation.

D'une manière générale, le dispositif de l'invention permet de maintenir une plaque (102) à tactiliser dans un bâti (104). Le bâti présente un rebord supérieur (104-a) et un rebord inférieur (104-b). La plaque (102) présente une face supérieure (102-a) et une face opposée (102-b). Le dispositif de maintien de la plaque comprend un premier élément supérieur (106) qui s'étend entre la face supérieure (102-a) de la plaque et le rebord supérieur (104-a) du bâti. Le dispositif comprend de plus un second élément inférieur (108) qui s'étend entre la face opposée (102-b) de la plaque et le rebord inférieur (104-b) du bâti. L'élément inférieur est un composant capacitif qui permet de détecter un déplacement de la plaque lors d'une interaction avec celle-ci, comme un simple touché sur la surface. De manière préférentielle, le composant capacitif comprend une première électrode mobile solidaire de la face opposée de la surface tactile (102-b) et une deuxième électrode fixe solidaire du bâti (104-b).

Avantageusement, le dispositif de maintien de l'invention permet qu'une plaque soit retenue entre les rebords supérieur et inférieur du bâti par un agencement et une répartition d'éléments supérieurs élastiques et d'éléments inférieurs capacitifs. La plaque se retrouve alors pincée par le dispositif qui assure son maintien.

L'élément supérieur (106) est un élément élastique qui peut être fait de différents matériaux rigides ou semi-rigides tels que par exemple des polymères ou de la mousse ou un ressort afin de permettre une déformation suffisante lors d'une interaction sur la surface de la plaque, et reprendre leur forme initiale de repos.

L'élément supérieur élastique déformable utilisé dans l'invention peut être de différentes formes et configurations. Dans un mode de réalisation tel qu'illustré sur la figure 1, il est de forme sensiblement identique à l'élément inférieur capacitif et est placé en regard de ce dernier (108).

En pratique, chaque élément supérieur élastique peut être collé au bâti et à la surface à tactiliser.

De même, l'élément supérieur peut avoir une épaisseur de repos variable qui soit identique ou différente de l'épaisseur de l'élément inférieur capacitif.

L'homme du métier comprendra que les exemples décrits ne sont pas limitatifs et que le dispositif de l'invention peut comprendre des éléments élastiques et capacitifs qui soient en nombre identique ou différent selon la taille ou la forme de la surface à tactiliser ou selon l'application. Dans une implémentation préférentielle, les moyens élastiques sont au minimum au nombre de trois et les moyens capacitifs sont au minimum au nombre de trois. Par exemple, dans une application pour un plafonnier de véhicule, la vitre du plafonnier pourra être retenue dans un bâti par quatre dispositifs positionnés à chaque coin de la surface.

La figure 2 montre en vue de côté une variante d'implémentation du dispositif de maintien de l'invention dans lequel l'élément déformable est composé d'un élément capacitif. Le dispositif de maintien dans cette variante est constitué de deux capteurs capacitifs assemblés en un dispositif capacitif unitaire, dit capteur fourche. Le capteur fourche comprend une armature centrale (208-a, 208-b) solidaire de la surface 202, et deux armatures externes (210-a, 210-b) solidaires des rebords du bâti, les armatures externes étant respectivement séparées de l'armature centrale par un matériau diélectrique (206-a, 206-b).

Les capteurs capacitifs sont situés respectivement de part et d'autre de la plaque 202 présentant une face supérieure et une face inférieure. Dans le contexte de l'invention, le capteur situé au-dessus de la plaque est dit 'capteur supérieur' et le capteur situé au-dessous de la plaque est dit 'capteur inférieur'. Dans une implémentation, les capteurs sont disposés sur les bords de la plaque et encastrés dans un bâti 204. Ainsi avantageusement, le capteur fourche permet le maintient de la surface 202 sans système de fixation complémentaire.

Pour permettre de détecter un déplacement de la plaque lors d'une interaction sur la surface, chaque capteur comprend deux électrodes séparées par un diélectrique (206-a, 206-b). Le capteur supérieur comprend une première électrode 208-a solidaire de la plaque et une deuxième électrode 210-a solidaire du bâti. Un diélectrique 206-a constitué d'une matière élastique et isolante, comme par exemple du silicone ou du polyuréthane, est situé entre les deux électrodes. Le diélectrique permet d'augmenter la capacité mesurée en augmentant la permittivité du milieu. D'autre part, il constitue une fonction de rappel qui se comprime lorsqu'une force liée à une interaction est appliquée sur la surface pour rapprocher les deux électrodes, et qui se détend lorsque la force disparait afin de remettre les électrodes dans leur position initiale.

De manière similaire, le capteur inférieur comprend une première électrode 208-b solidaire de la plaque et une deuxième électrode 210-b solidaire du bâti, séparées par un diélectrique 206-b.

Chaque électrode solidaire de la plaque est mobile sous l'effet d'une pression sur la plaque et de la déformation du diélectrique. Chaque électrode solidaire du bâti est fixe et constitue une électrode de signal qui permet la mesure d'efforts exercés sur la surface. Le dispositif de maintien de l'invention à base de capteur fourche peut être couplé à un système de détection et de localisation d'interaction tel que celui décrit dans la demande de brevet du déposant intitulée « Procédé et dispositif pour localiser une interaction sur une surface tactile » déposée le même jour.

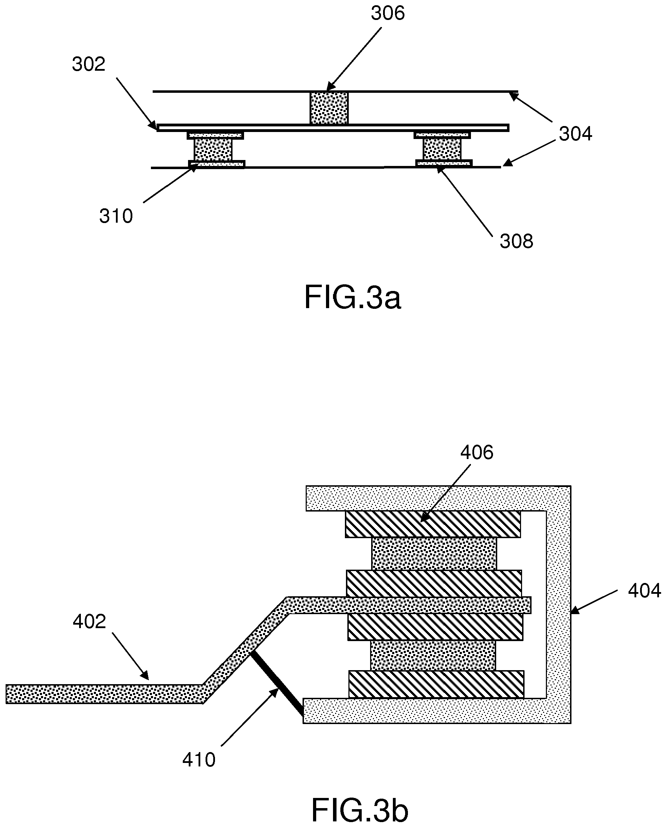

Les figures 3a et 3b montrent des variantes d'agencement du dispositif de maintien de l'invention.

La figure 3a est une vue de côté qui illustre un exemple de réalisation du dispositif de maintien où l'élément supérieur déformable (306) n'est pas en regard direct d'un élément capacitif (308). Dans la configuration de la figure 3a, l'élément supérieur déformable est positionné à intervalle régulier entre deux éléments capacitifs (308, 310). Avantageusement, un élément supérieur déformable peut être disposé de manière à être en regard total ou partiel d'un élément inférieur capacitif.

Selon les variantes d'implémentation, l'élément supérieur déformable peut être un élément capacitif tel que décrit en référence à la figure 2.

La figure 3b illustre une variante d'implémentation du dispositif de maintien de l'invention, dans lequel un joint (410) est ajouté entre la plaque (402) et le rebord inférieur du bâti (404) pour éviter un aspect cuvette qui peut se produire sur certaines surfaces de grande taille. Le rôle du joint est alors d'assurer l'étanchéité face aux poussières et aux liquides du système. Il est constitué d'un matériau étanche, tel un polymère ou un film plastique par exemple, et est déformable afin de perturber le moins possible la déformation des capteurs capacitifs. Celui-ci est collé à la fois sur le bâti (404) et sur la plaque (402). Dans cette variante, l'élément supérieur déformable (406) peut être un élément élastique ou un élément capacitif.

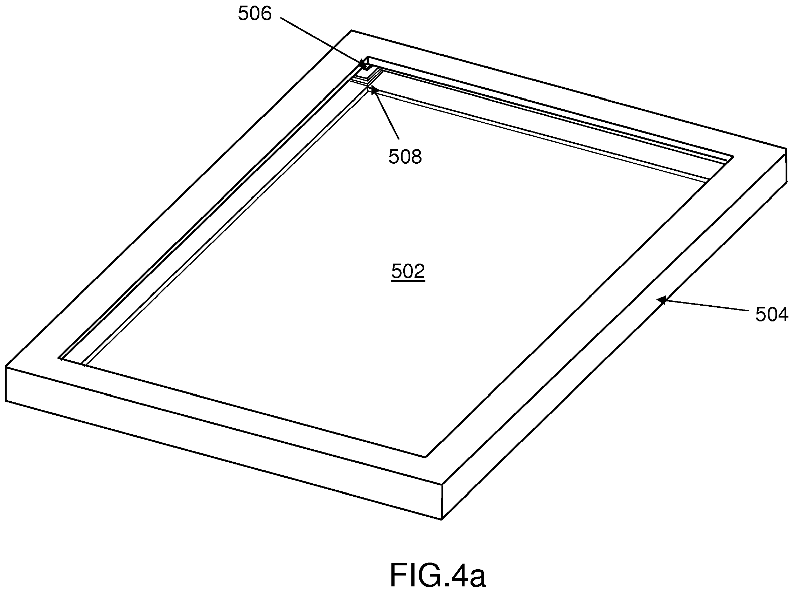

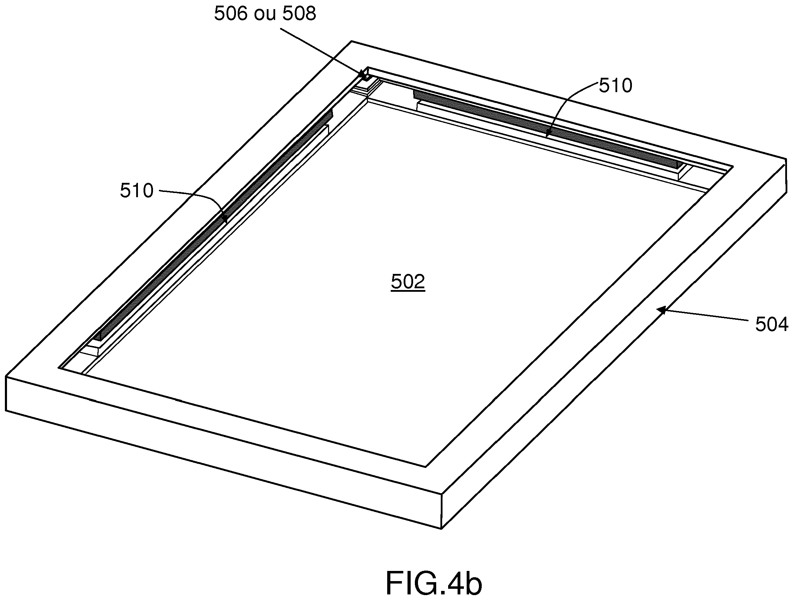

Les figures 4a et 4b illustrent un bâti sous une représentation 3D, permettant d'insérer une surface (502) à tactiliser de grande taille. Dans une implémentation préférentielle, le bâti est un bloc monolithique ou unitaire (504), formant une seule pièce dans laquelle la surface est encastrée. La surface peut être maintenue selon les variantes décrites en référence aux figures 1 à 3, soit par des paires de capteurs fourches (506, 508), soit par des capteurs supérieurs (506) ou inférieurs (508) et des éléments déformables (510) placés respectivement sur la face opposée de la surface. Tel que décrit précédemment, le nombre de capteurs peut varier d'au moins trois capteurs à une pluralité répartis sur le pourtour du bâti. Le nombre et la position des capteurs et des éléments de fixation déformables peuvent varier selon la taille et la rigidité de la surface. Dans une implémentation préférentielle, la surface est maintenue par quatre paires de capteurs fourches positionnés à chaque coin du bâti.

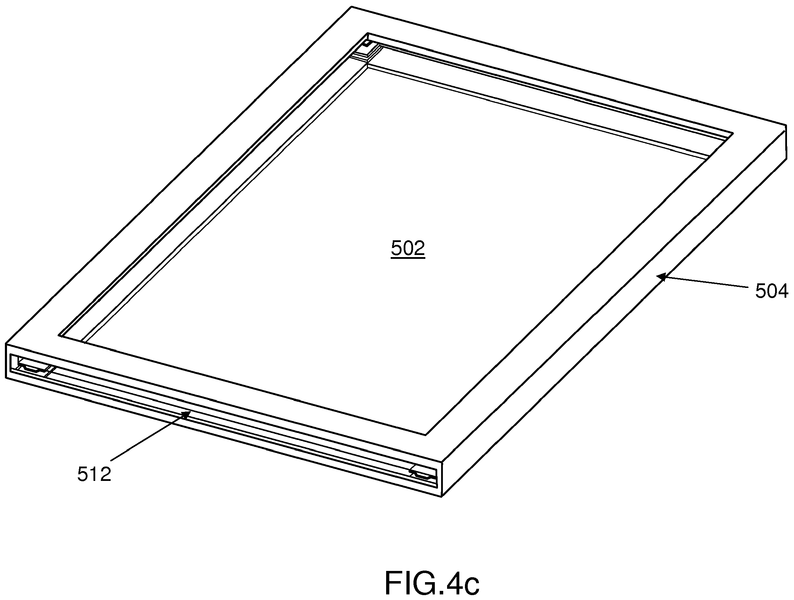

La Figure 4c illustre une variante de bâti monolithique ayant une ouverture latérale (512) permettant de glisser la surface à l'intérieur du bâti.

Selon d'autres variantes, le bâti peut comporter une pièce amovible (non illustré) qui peut être vissée ou collée sur le bâti après l'insertion de la surface pour fermer le bâti et apporter une protection supplémentaire.

Plus généralement, le bâti est une structure rigide qui peut être fait de différents matériaux rigides ou semi-rigides tels que par exemple des métaux (acier, aluminium,...) et des plastiques (ABS, PC,...) afin d'avoir une résistance suffisante lors d'une interaction sur la surface de la plaque.

L'homme du métier comprendra que seuls quelques exemples sont décrits mais ne sont en rien limitatifs des possibilités d'agencement entre les éléments supérieur déformables et les éléments inférieurs capacitifs. Ainsi avantageusement, selon la taille de la surface à tactiliser, des modules de fixation peuvent être facilement ajoutés ou retirés. Dans une variante, une même surface peut être maintenue dans un bâti par des modules.

## Revendications

1. Un dispositif pour maintenir une surface à tactiliser, la dite surface présentant une face supérieure et une face opposée et étant tactilisable par des moyens capacitifs aptes à détecter un appui sur ladite surface, le dispositif comprenant :
- les moyens capacitifs (308, 508);
- un bâti monolithique (504), présentant un rebord supérieur et un rebord inférieur, pour encastrer la surface à tactiliser (502) de telle sorte que les moyens capacitifs (308, 508) soient agencés sur le pourtour du bâti entre le rebord inférieur du bâti et la face opposée de la surface ;
- des moyens déformables (306, 510) agencés sur le pourtour du bâti monolithique entre le rebord supérieur du bâti et la face supérieure de la surface;
chaque moyen déformable étant positionné à intervalle régulier entre deux moyens capacitifs.

2. Le dispositif selon la revendication 1 dans lequel les moyens déformables sont disposés en regard partiel des moyens capacitifs.

3. Le dispositif selon l'une quelconque des revendications 1 à 2 dans lequel les moyens déformables sont en matériau rigide ou semi-rigide.

4. Le dispositif selon l'une quelconque des revendications 1 à 2 dans lequel les moyens déformables sont des capteurs capacitifs.

5. Le dispositif selon la revendication 4 dans lequel les capteurs capacitifs sont couplés aux moyens capacitifs disposés entre le rebord inférieur du bâti et la face opposée de la surface pour coopérer lors de la détection d'une interaction sur la surface.

6. Le dispositif selon la revendication 5 dans lequel un capteur capacitif comprend une première électrode solidaire de la surface et une deuxième électrode séparée de la première par un diélectrique et solidaire du bâti.

7. Le dispositif selon l'une quelconque des revendications 1 à 6 comprenant au moins un joint qui s'étend entre la surface et le rebord inférieur du bâti.

8. Le dispositif selon l'une quelconque des revendications 1 à 7 dans lequel la surface est un plafonnier de véhicule.

9. Le dispositif selon l'une quelconque des revendications 1 à 8 dans lequel les moyens déformables sont au minimum au nombre de trois et les moyens capacitifs sont au minimum au nombre de trois.

## Patentansprüche

1. Vorrichtung zum Halten einer berührungsempfindlich zu machenden Oberfläche, wobei die Oberfläche eine obere Seite und eine gegenüberliegende Seite aufweist und mit kapazitiven Mitteln berührungsempfindlich gemacht werden kann, die ein Drücken gegen die Oberfläche erkennen können, wobei die Vorrichtung Folgendes umfasst:
- kapazitive Mittel (308, 508);
- ein monolithisches Gehäuse (504), das einen oberen Rand und einen unteren Rand aufweist, zum Einfassen der berührungsempfindlich zu machenden Oberfläche (502) auf eine solche Weise, dass die kapazitiven Mittel (308, 508) am Umfang des Gehäuses zwischen dem unteren Rand des Gehäuses und der gegenüberliegenden Seite der Oberfläche angeordnet sind;
- verformbare Mittel (306, 510), die am Umfang des monolithischen Gehäuses zwischen dem oberen Rand des Gehäuses und der oberen Seite der Oberfläche angeordnet sind;
wobei die einzelnen verformbaren Mittel in regelmäßigen Abständen zwischen zwei kapazitiven Mitteln positioniert sind.

2. Vorrichtung nach Anspruch 1, bei der die verformbaren Mittel den kapazitiven Mitteln teilweise gegenüberliegend angeordnet sind.

3. Vorrichtung nach einem der Ansprüche 1 bis 2, bei der die verformbaren Mittel aus einem starren oder halbstarren Material sind.

4. Vorrichtung nach einem der Ansprüche 1 bis 2, bei der die verformbaren Mittel kapazitive Sensoren sind.

5. Vorrichtung nach Anspruch 4, bei der die kapazitiven Sensoren mit den zwischen dem unteren Rand des Gehäuses und der gegenüberliegenden Seite der Oberfläche angeordneten kapazitiven Mitteln gekoppelt sind, um beim Erkennen einer Interaktion auf der Oberfläche zusammenzuwirken.

6. Vorrichtung nach Anspruch 5, bei der ein kapazitiver Sensor eine erste Elektrode einstückig mit der Oberfläche und eine zweite Elektrode von der ersten durch ein Dielektrikum getrennt und einstückig mit dem Gehäuse umfasst.

7. Vorrichtung nach einem der Ansprüche 1 bis 6, die wenigstens eine Dichtung umfasst, die zwischen der Oberfläche und dem unteren Rand des Gehäuses verläuft.

8. Vorrichtung nach einem der Ansprüche 1 bis 7, bei der die Oberfläche eine Fahrzeugdeckenleuchte ist.

9. Vorrichtung nach einem der Ansprüche 1 bis 8, bei der die Anzahl von verformbaren Mitteln wenigstens drei beträgt und die Anzahl der kapazitiven Mittel wenigstens drei beträgt.

## Claims

1. A device for holding a surface to be touch-sensitized, said surface having an upper face and an opposite face and being touch-sensitized by capacitive means capable of detecting a displacement of said surface, the device comprising:
- capacitive means (308, 508);
- a monolithic frame (504), having an upper rim and a lower rim, for embedding the surface to be touch-sensitized (502), such that the capacitive means (308, 508) are arranged on the perimeter of the frame between the lower rim of the frame and the opposite face of the surface;
- deformable means (306, 510) arranged on the perimeter of the monolithic frame between the upper rim of the frame and the upper face of the surface;
each deformable means being positioned at an equal distance between two capacitive means.

2. The device as claimed in claim 1, in which the deformable means are arranged partially overlapping the capacitive means.

3. The device as claimed in any one of claims 1 to 2, in which the deformable means are of rigid or semi-rigid material.

4. The device as claimed in any one of claims 1 to 2, in which the deformable means are capacitive sensors.

5. The device as claimed in claim 4, in which the capacitive sensors are coupled to the capacitive means arranged between the lower rim of the frame and the opposite face of the surface to cooperate in the detection of an interaction on the surface.

6. The device as claimed in claim 5, in which a capacitive sensor comprises a first electrode secured to the surface and a second electrode separated from the first by a dielectric and secured to the frame.

7. The device as claimed in any one of claims 1 to 6, comprising at least one seal which extends between the surface and the lower rim of the frame.

8. The device as claimed in any one of claims 1 to 7, in which the surface is a vehicle dome light.

9. The device as claimed in any one of claims 1 to 8, in which there are at least three of the deformable means and there are at least three of the capacitive means.
